Europäisches Patentamt

European Patent Office

Office européen des brevets

(11) Veröffentlichungsnummer: **0 323 584 B1**

(12) **EUROPÄISCHE PATENTSCHRIFT**

(45) Veröffentlichungstag der Patentschrift: **19.07.95**

(51) Int. Cl.6: **C08G 59/68**, C08J 5/24

(21) Anmeldenummer: **88120722.9**

(22) Anmeldetag: **12.12.88**

Die Akte enthält technische Angaben, die nach dem Eingang der Anmeldung eingereicht wurden und die nicht in dieser Patentschrift enthalten sind.

(54) **Verfahren zur Herstellung von Schichtpresstoffen.**

(30) Priorität: **15.12.87 CH 4881/87**

(43) Veröffentlichungstag der Anmeldung:
**12.07.89 Patentblatt 89/28**

(45) Bekanntmachung des Hinweises auf die Patenterteilung:
**19.07.95 Patentblatt 95/29**

(84) Benannte Vertragsstaaten:
**AT BE CH DE ES FR GB IT LI NL SE**

(56) Entgegenhaltungen:
**EP-A- 0 109 851**
**EP-A- 0 153 904**
**EP-A- 0 182 744**
**EP-A- 0 284 064**
**AT-B- 384 025**

(73) Patentinhaber: **CIBA-GEIGY AG**
**Klybeckstrasse 141**
**CH-4002 Basel (CH)**

(72) Erfinder: **Meier, Kurt, Dr.**
**Im Kirschgarten 35**
**CH-4102 Binningen (CH)**
Erfinder: **Haug, Theobald, Dr.**
**Untere Flühackerstrasse 12**
**CH-4402 Frenkendorf (CH)**
Erfinder: **Scharf, Wolfgang, Dr.**
**Röttler Ring 11c**
**D-7889 Grenzach-Wyhlen (DE)**

(74) Vertreter: **Zumstein, Fritz, Dr. et al**
**Patentanwälte,**
**Dr. F. Zumstein,**
**Dipl.-Ing. F. Klingseisen,**
**Bräuhausstrasse 4**
**D-80331 München (DE)**

## Beschreibung

Die Erfindung betrifft ein Verfahren zur Herstellung von Schichtpressstoffen, die daraus erhältlichen Produkte und die Verwendung von speziellen Härtern zur Herstellung von Schichtpressstoffen.

Kationisch härtbare Gemische enthaltend Metallocenkomplexsalze als Initiatoren sind aus der EP-A-94,915 bekannt.

Zur Herstellung von Schichtpressstoffen auf Epoxidbasis verwendet man im allgemeinen ausgewählte Härter/Beschleuniger Kombinationen, beispielsweise die Kombination Dicyandiamid/Benzyldimethylamin.

Die Harzformulierungen müssen einer Reihe von Anforderungen entsprechen, die teilweise schwierig miteinander zu vereinbaren sind.

So sollten beispielsweise eine ausreichende Lagerstabilität des Prepregs und eine rasche Aushärtung des Matrixharzes im Presswerkzeug gegeben sein. Ferner sollte die Viskosität des Matrixharzes sich zu Beginn des Pressvorganges erniedrigen, um eingeschlossene Gase aus dem zu verpressenden Material zu entfernen. Dabei sollte der Viskositätsabfall aber nur soweit erfolgen, dass nur ein geringer Teil des Harzes aus der Fasermatrix herausfliesst.

Bei vorbekannten Verfahren beginnt die Vernetzungsreaktion in der Regel bereits auf der Stufe der Prepregherstellung, da die bekannten Härter/Beschleuniger Kombinationen bereits eine gewisse Reaktion mit dem Epoxidharz eingehen. Beim Pressvorgang müssen daher Druck und Temperatur entsprechend der genannten Reaktion variiert werden, um den gewünschten Viskositätsverlauf des Matrixharzes zu erhalten.

Es wurde jetzt ein Verfahren zur Herstellung von Schichtpressstoffen gefunden, bei dem Druck- und Temperaturverlauf im Presschritt in weiten Grenzen variiert werden können und bei dem mit gegenüber herkömmlichen Verfahren verkürzten Presszyklen gearbeitet werden kann. Ferner führt dieses Verfahren überraschenderweise zu Schichtpressstoffen mit verbesserten Endeigenschaften, wie erhöhter Glasübergangstemperatur der Harzmatrix oder geringerer Lösungsmittelaufnahmefähigkeit des Schichtpressstoffes.

In diesem Verfahren wird eine Harz/Initiator Kombination mit hoher Latenz verwendet, bei der die Verarbeitungsbedingungen so eingestellt werden können, so dass auf der Stufe der Prepregherstellung praktisch keine Vorvernetzung eintritt.

Das Verfahren beruht ferner auf der überraschenden Erkenntnis, dass die Härtungsreaktion im Presschritt rasch einsetzt und schnell abläuft. Dadurch lassen sich zu Beginn des Pressvorganges niedrige Viskositäten des Matrixharzes einstellen und der Vorgang lässt sich so steuern, dass nur ein gewünschter Anteil des Harzes aus der Fasermatrix herausfliesst.

Die vorliegende Erfindung betrifft ein Verfahren zur Herstellung eines Schichtpressstoffes umfassend die Schritte

i) Herstellung einer Schicht durch Kontaktieren eines faserförmigen Trägermaterials mit einer härtbaren Mischung enthaltend ein Epoxidharz mit durchschnittlich wenigstens zwei 1,2-Epoxidgruppen pro Molekül oder eine Mischung dieser Epoxidharze und eine Verbindung der Formel I oder eine Mischung dieser Verbindungen

$$\left[ R^1 (Fe^{II} R^2)_a \right]^{ab\oplus} \quad ab \cdot \left[ X \right]^{\ominus} \qquad (I),$$

worin a und b unabhängig voneinander 1 oder 2 sind, $R^1$ ein $\pi$-Aren ist, $R^2$ ein $\pi$-Aren oder ein Indenyl- oder Cyclopentadienylanion bedeutet, $X^-$ ein Anion $[LQ_m]^-$ oder ein Anion einer teil- oder perfluorierten aliphatischen oder aromatischen Sulfonsäure ist, L P, As oder Sb bedeutet, Q Fluor ist oder ein Teil der Reste Q auch Hydroxylgruppen sein können, und m der um Eins vergrösserten Wertigkeit von L entspricht,

ii) Herstellen einer Schichtfolge aus mindestens zwei schichtförmigen, miteinander zu verbindenden Materialien, wovon mindestens eines davon eine gemäss Schritt i) erhältliche Schicht ist, bei der das härtbare Material im wesentlichen in unveränderter Form vorliegt, und

iii) Verpressen besagter Schichtfolge bei erhöhter Temperatur, wobei Druck und Temperatur so gewählt werden, dass zu Beginn dieses Schrittes ein flüssiges Matrixharz vorliegt, bei dem anfänglich ein Viskositätsabfall erfolgt, so dass eingeschlossene Gase praktisch vollständig aus der Schichtfolge entweichen können, und dass bei der folgenden Vernetzungsreaktion der Viskositätsanstieg so rasch erfolgt, dass das ausfliessende Harz das Presswerkzeug nicht verklebt.

Als Trägermaterialien sind im Prinzip alle Fasern geeignet, die mit der Epoxidmatrix einen Verbund ausbilden können und eine Verstärkung des Matrixmaterials bewirken.

Beispiele für Fasermaterialien sind natürliche Polymere, wie Cellulose; Metalle, wie Stahl, Ti, W, Ta oder Mo; organische faserbildende Polymere, insbesondere aromatische Polyamide, wie Nomex oder Kevlar; Kohlenstoff, wie z.B. durch Carbonisieren von Cellulose, Polyacrylnitril oder Pech hergestellte Materialien; und insbesondere Glas.

Die Fasermaterialien können in unterschiedlichsten Formen als Träger eingesetzt werden. Sie lassen sich beispielsweise als Endlosfäden (einzelne Fäden oder Spinnfäden), Endlosgarne, Parallelrovings, als gewebte Endlosgarne, Spinnrovings, Rovinggewebe, Kurzfasern, Endlosmatten, Schnittmatten, Vliesstoffe oder Filze (Papiere) verwenden.

Das Kontaktieren des faserförmigen Trägermaterials mit dem härtbaren Gemisch wird je nach Fasertyp und Faserform oder den Eigenschaften des Matrixmaterials unterschiedlich sein. Beispiele für solche Verfahren sind das Imprägnieren von Geweben, Vliesen oder Endlosfasern mit der flüssigen Harz/Initiatormischung oder mit einer Lösung einer festen Harz/Initiatormischung in einem inerten Lösungsmittel.

Schichten enthaltend Kurzfasern können beispielsweise durch Aufbringen der härtbaren Mischung zusammen mit geschnittenen Fasern auf ein Gewebe oder eine Metallfolie hergestellt werden.

Das Kontaktieren des faserförmigen Trägermaterials mit dem härtbaren Gemisch erfolgt vorzugsweise durch Imprägnieren. Dazu durchlaufen Gewebebahnen aus besagtem Trägermaterial beispielsweise ein Harzbad, enthaltend das Epoxidharz, den Initiator und gegebenenfalls ein Lösungsmittel, werden gegebenenfalls getrocknet und anschliessend auf eine Vorratsspule aufgewickelt.

Vor Schritt ii) empfiehlt es sich, die imprägnierten Schichten einem Belichtungsschritt auszusetzen. Dadurch wird die Verbindung der Formel I in eine aktivierte Form übergeführt. Die nachfolgende Heisshärtung lässt sich durch diese Behandlung bei tieferen Temperaturen durchführen, als bei der direkten Heisshärtung benötigt würden.

Bevorzugt wird also ein Verfahren umfassend die oben definierten Schritte i), ii) und iii), worin vor Schritt ii) noch ein Bestrahlungsschritt ia) eingeschaltet ist, worin die Verbindung der Formel I zur Aktivierung mit aktinischer Strahlung bestrahlt wird.

Dabei kann das in Schritt i) erhaltene Prepreg bestrahlt werden oder man imprägniert ein faserförmiges Trägermaterial mit einer vorher bestrahlten Mischung aus Epoxidharz und Initiator der Formel I.

Intensität und Wellenlänge der zu verwendenden Strahlung richtet sich nach der Art des Initiators; je nach Natur des Arenliganden $R^1$ kann sich die Absorption des Initiators im UV-Bereich oder im sichtbaren Bereich bewegen, beispielsweise im Bereich von 250-600 nm.

Das härtbare Gemisch kann, je nach Natur des Initiators, zusätzlich noch einen Sensibilisator für besagten Initiator enthalten. Ferner kann das härtbare Gemisch Kombinationen von Verbindungen der Formel I mit Oxidationsmitteln enthalten. Diese Ausführungsformen sind in den EP-A-152,377 bzw. EP-A-126,712 beschrieben. Die Beschreibungen dieser Publikationen sind ebenfalls Gegenstand der vorliegenden Beschreibung.

Nach dem Imprägnieren und Belichten kann es sich anbieten, das Material kurzfristig zu erhitzen, beispielsweise auf 70-120 °C, um die Viskosität des Harzes zu erhöhen, bevor Schritt ii) ausgeführt wird.

In Schritt ii) werden einzelne Schichten aus dem vorangehend erhaltenen Material in der gewünschten Anzahl übereinander verlegt. Dabei kann es sich um jeweils gleiche Schichten handeln oder es können noch Schichten aus weiteren Materialien anwesend sein.

Beispiele für Schichten aus weiteren Materialien sind Metallfolien, wie Kupferfolien oder Aluminiumfolien, oder weitere Verstärkungsmittel, wie Matten oder Vliese aus faserförmigem Verstärkungsmaterial.

In Schritt iii) wird die gemäss ii) erhaltene Anordnung durch Verpressen und Erhitzen gehärtet.

Die Verfahrensbedingungen in Schritt iii) können konstant gehalten oder variiert werden. So kann man beispielsweise in einer ersten Stufe Druck und Temperatur in einer Weise vorgeben, so dass im wesentlichen noch keine Härtung abläuft oder die Härtungsgeschwindigkeit so langsam ist und die Viskosität des Harzes infolge der Temperaturerhöhung auf das gewünschte Ausmass absinkt. Anschliessend können Druck und/oder Temperatur erhöht werden, so dass die gewünschte Geschwindigkeit des Viskositätsanstieges erzielt wird. Diese Erhöhungen können kontinuierlich oder stufenweise erfolgen. So kann beispielsweise den Druck entsprechend dem Viskositätsanstieg stufenweise erhöhen, während die Temperatur kontinuierlich erhöht wird.

Druck und Temperatur können aber auch zu Beginn von Schritt iii) fest vorgegeben werden, so dass die Vernetzungsreaktion praktisch sofort einsetzt. Dieses Vorgehen empfiehlt sich bei flüssigen Matrixharzen niedriger Viskosität. Hier genügt in der Regel das anfängliche Pressen, um eingeschlossene Gase aus dem Schichtstoff zu entfernen. In solchen Systemen wird es im allgemeinen nur einen kurzen Viskositätsabfall geben, bevor die Härtungsreaktion zu einem Anstieg der Viskosität führt.

Schritt iii) kann diskontinuierlich in Etagenpressen oder kontinuierlich in Doppelbandpressen erfolgen.

In einer bevorzugten Ausführungsform des Verfahrens werden Schritte ii) und iii) kontinuierlich ausgeführt. Dazu führt man beispielsweise Bahnen des gemäss Schritt i) erhältlichen Materials gegebenenfalls zusammen mit Bahnen weiterer schichtförmiger miteinander zu verbindender Materialien in der jeweils gewünschten Schichtfolge gleichzeitig zwischen beheizbaren Doppelbandpressen hindurch.

Schritt i) kann bei dieser Ausführungsform separat ausgeführt werden, indem man das faserförmige Trägermaterial mit dem härtbaren Gemisch kontaktiert und die erhaltenen Bahnen auf Vorratsrollen aufwickelt.

Schritt i) kann aber auch zusammen mit den Schritten ii) und iii) kontinuierlich ausgeführt werden, indem man beispielsweise Bahnen des faserförmigen Trägermaterials unmittelbar vor Schritt ii) durch ein Harzbad führt.

Bei der kontinuierlichen Arbeitsweise werden bevorzugt besonders rasch wirkende Initiatoren der Formel I eingesetzt. Dabei handelt es sich insbesondere um Verbindungen der Formel I, worin $X^{\ominus}$ $AsF_6^-$ und ganz besonders $SbF_6^-$ ist.

Die Bahnen aus imprägniertem Material werden bei dieser Ausführungsform vor dem Durchführen durch die Doppelbandpresse in der Regel mit aktinischer Strahlung, insbesondere mit UV/VIS-Strahlung, bestrahlt.

Dies kann bereits vor oder direkt nach dem Imprägnieren erfolgen oder kurz vor dem eigentlichen Kontaktschritt.

Die Pressdrucke in Schritt iii) betragen im allgemeinen 1-60 bar, vorzugsweise 20-50 bar; die Härtungstemperaturen liegen im allgemeinen bei 50-250 °C, vorzugsweise bei 80-200 °C. Die Pressdauer beläuft sich, abhängig vom jeweiligen härtbaren Gemisch, im allgemeinen auf 0,1-120 Minuten.

Pressdrucke und -temperaturen hängen im allgemeinen vom jeweils verwendeten härtbaren Gemisch ab. Bei der Auswahl der experimentellen Parameter spielen beispielsweise Reaktivität und Aggregatzustand des jeweiligen Harz/Härter Gemisches eine Rolle.

Die im Einzelfall notwendigen Bedingungen können vom Fachmann anhand der oben angegebenen Kriterien ausgewählt und optimiert werden.

Als Epoxidharz mit durchschnittlich wenigstens zwei 1,2-Epoxidgruppen pro Molekül eignen sich praktisch alle Epoxidharze. Beispiele dafür sind:

I) Polyglycidyl- und Poly-($\beta$-methylglycidyl)-ester, die sich von Verbindungen mit mindestens zwei Carboxylgruppen im Molekül und Epichlorhydrin bzw. Glyzerindichlorhydrin bzw. $\beta$-Methylepichlorhydrin ableiten.

Als Verbindungen mit mindestens zwei Carboxylgruppen im Molekül können aliphatische Polycarbonsäuren verwendet werden. Beispiel für diese Polycarbonsäuren sind Oxalsäure, Bernsteinsäure, Glutarsäure, Adipinsäure, Pimelinsäure, Korksäure, Azelainsäure, Sebazinsäure oder dimerisierte bzw. trimerisierte Linolsäure.

Es können aber auch cycloaliphatische Polycarbonsäuren eingesetzt werden, wie beispielsweise Tetrahydrophthalsäure, 4-Methyltetrahydrophthalsäure, Hexahydrophthalsäure oder 4-Methylhexahydrophthalsäure.

Weiterhin können aromatische Polycarbonsäuren Verwendung finden, wie beispielsweise Phthalsäure, Isophtalsäure oder Terephthalsäure.

II) Polyglycidyl- oder Poly-($\beta$-methylglycidyl)-ether, die sich von Verbindungen mit mindestens zwei freien alkoholischen Hydroxygruppen und/oder phenolischen Hydroxygruppen und einem geeignet substituierten Epichlorhydrin ableiten.

Beispiele für Verbindungen mit mindestens zwei alkoholischen Hydroxylgruppen sind acyclische Alkohole, wie Ethylenglykol, Diethylenglykol und höhere Poly-(oxyethylen)-glykole, Propan-1,2-diol oder Poly-(oxypropylen)-glykole, Propan-1,3-diol, Butan-1,4-diol, Poly-(oxytetramethylen)-glykole, Pentan-1,5-diol, Hexan-1,6-diol, Hexan-2,4,6-triol, Glycerin, 1,1,1-Trimethylolpropan, Pentaerythrit, Sorbit, sowie Polyepichlorhydrine.

Solche Ether können sich auch von cycloaliphatischen Alkoholen ableiten, wie von 1,3- oder 1,4-Dihydroxycyclohexan, Bis-(4-hydroxycyclohexyl)-methan, 2,2-Bis(4-hydroxycyclohexyl)-propan oder 1,1-Bis-(hydroxymethyl)-cyclohex-3-en.

Die Epoxidverbindungen können sich auch von einkernigen Phenolen ableiten, wie beispielsweise von Resorcin oder Hydrochinon; oder sie basieren auf mehrkernigen Phenolen wie beispielsweise auf Bis-(4-hydroxy-phenyl)-methan, 4,4'-Dihydroxydiphenyl, Bis-(4-hydroxyphenyl)-sulfon, 1,1,2,2-Tetrakis-(4-hydroxyphenyl)-ethan, 2,2-Bis-(4-hydroxyphenyl)-propan, 2,2-Bis-(3,5-dibrom-4-hydroxyphenyl)-propan sowie auf Novolaken erhältlich durch Kondensation von Aldehyden, wie beispielsweise Formaldehyd, Acetaldehyd, Chloral oder Furfuraldehyd mit Phenolen wie Phenol, oder mit Phenolen, die im Kern mit Chloratomen oder $C_1$-$C_9$ Alkylgruppen substituiert sind, wie beispielsweise 4-Chlorphenol, 2-Methylphenol oder 4-tert. Butylphenol oder erhältlich durch Kondensation mit Bisphenolen, so wie oben beschrieben.

Zu diesen Epoxidharzen zählen auch die durch sogenannte Vorverlängerung, das heisst, durch Umsetzung von relativ niedrigmolekularen und tiefschmelzenden oder flüssigen Epoxidharzen mit polyfunktionellen Verbindungen erhältliche höhermolekulare und höherschmelzende Epoxidharze. Ausgangsprodukte für solche Vorverlängerungsreaktionen sind beispielsweise niedrigmolekulare Diglycidylether auf Bisphenol-Basis, wie Bisphenol-A-Basis, die mit einem Unterschuss eines Bisphenols, wie Bisphenol-A oder Tetrabrombisphenol-A, in an sich bekannter Weise zu höhermolekularen Verbindungen umgesetzt werden.

Solche Umsetzungen sind an sich bekannt und beispielsweise in Kirk-Othmer "Encyclopedia of Chemical Technology", Band 9, S. 275-276 (J. Wiley & Sons, New York 1980) beschrieben.

III) Poly-(S-glycidyl) Verbindungen, insbesondere Di-S-glycidylderivate, die sich von Dithiolen, wie beispielsweise Ethan-1,2-dithiol oder Bis-(4-merkaptomethylphenyl)-ether ableiten.

IV) Cycloaliphatische Epoxidharze, wie Bis-(2,3-epoxicyclopentyl)-ether, 2,3-Epoxicyclopentylglycidylether oder 1,2-Bis-(2,3-epoxicyclopentyloxy)-ethan oder 3,4-Epoxicyclohexylmethyl-3',4'-epoxicyclohexancarboxylat.

Es lassen sich aber auch Epoxidharze verwenden, bei denen die 1,2-Epoxidgruppen an unterschiedliche Heteroatome bzw. funktionelle Gruppen gebunden sind; zu diesen Verbindungen zählen beispielsweise der Glycidylether-glycidylester der Salicylsäure.

Falls gewünscht, kann eine Mischung von Epoxidharzen in den härtbaren Mischungen verwendet werden.

Zur Steuerung des Viskositätsverlaufs in Stufe iii) kann es sich anbieten, in Stufe i) ein modifiziertes Epoxidharz einzusetzen, um eine höhere Anfangsviskosität und um einen schnelleren Anstieg der Viskosität beim Pressschritt zu erzielen.

Dazu kann man das Epoxidharz beispielsweise durch teilweise Umsetzung mit einem bei erhöhter Temperatur wirksamen Epoxidhärter, wie beispielsweise mit einem Anhydridhärter, modifizieren; oder man kombiniert das Epoxidharz mit einer geringen Menge eines Polyphenols, insbesondere eines Novolaks.

Die Menge an Modifizierungsmitteln wird so gewählt, dass ein Viskositätsaufbau des zu modifizierenden Harzes erfolgt, der aber nicht so gross ist, dass der anfängliche Viskositätsabfall des Epoxidharzes in Schritt iii) unterbleibt.

Vorzugsweise setzt man in dieser Ausführungsform einen Polyglycidylether, insbesondere einen Diglycidylether auf Bisphenol Basis, der gegebenenfalls auch vorverlängert sein kann, teilweise mit einem cyclischen Anhydrid einer Polycarbonsäure, insbesondere einem Anhydrid einer cycloaliphatischen Dicarbonsäure, um; in einer weiteren bevorzugten Ausführungsform dieser Variante kombiniert man einen Polyglycidylether, insbesondere einen Diglycidylether auf Bisphenol Basis, der gegebenenfalls auch vorverlängert sein kann, mit einer geringen Menge eines Novolaks, insbesondere eines Phenol-Formaldehyd-Novolaks oder eines Kresol-Formaldehyd-Novolaks.

Ein $\pi$-Aren $R^1$ oder $R^2$ ist im allgemeinen ein nichtbasischer heterocyclisch-aromatischer oder insbesondere ein carbocyclisch-aromatischer Rest, der ein- oder mehrkernig und, im Falle mehrkernigen Resten, unkondensiert oder kondensiert sein kann. Diese Reste können unsubstituiert sein oder sie sind mit nichtbasischen Resten substituiert.

Als $\pi$-Aren $R^1$ oder $R^2$ kommen insbesondere carbocyclisch-aromatischeKohlenwasserstoffe mit 6 bis 24 Kohlenstoffatomen, insbesondere mit 6 bis 12 Kohlenstoffatomen, oder heterocyclisch-aromatische Kohlenwasserstoffe mit 4 bis 11 Kohlenstoffatomen und 1 bis 2 O- oder S-Atomen in Betracht, wobei diese Gruppen gegebenenfalls durch gleiche oder verschiedene einwertige Reste, wie Halogenatome, vorzugsweise Chlor-oder Bromatome, oder $C_1$-$C_8$-Alkyl, $C_1$-$C_8$-Alkoxy-oder Phenylgruppen einfach oder mehrfach substituiert sein können. Unkondensierte, mehrkernige $\pi$-Arengruppen können direkt oder über Brückenglieder, wie -$CH_2$-, -$C(CH_3)_2$-, -CH = CH-, -O-, -S-, -$SO_2$- oder -CO-, verknüpft sein.

Die Alkyl- oder Alkoxygruppen können dabei geradkettig oder verzweigt sein. Als typische Alkyl- oder Alkoxygruppen seien Methyl, Ethyl, n-Propyl, Isopropyl, n-Butyl, sek.-Butyl, tert.-Butyl, n-Pentyl, n-Hexyl und n-Octyl, Methoxy, Ethoxy, n-Propoxy, Isopropoxy, n-Butoxy, n-Hexyloxy und n-Octyloxy genannt. Alkyl-oder Alkoxygruppen mit 1 bis 4 Kohlenstoffatomen sind bevorzugt. Als substituierte $\pi$-Arene werden solche bevorzugt, die einen oder zwei der obengenannten Substituenten, insbesondere Methyl-, Ethyl-, n-Propyl, Isopropyl, Methoxy- oder Ethoxygruppen, enthalten.

$R^2$ kann darüber hinaus ein Indenylanion und insbesondere ein Cyclopentadienylanion sein, wobei auch diese Anionen gegebenenfalls durch gleiche oder verschiedene einwertige Reste wie $C_1$-$C_8$-Alkyl oder $C_1$-$C_8$-Alkoxygruppen einfach oder mehrfach, insbesondere einfach, substituiert sein können. $R^2$ ist bevorzugt

ein unsubstituiertes Indenylanion und besonders bevorzugt ein unsubstituiertes Cyclopentadienylanion.

Beispiele für geeignete $\pi$-Arene $R^1$ oder $R^2$ sind Benzol, Toluol, Xylole, Ethylbenzol, Cumol, Methoxybenzol, Ethoxybenzol, Dimethoxybenzol, p-Chlortoluol, m-Chlortoluol, Chlorbenzol, Brombenzol, Dichlorbenzol, Trimethylbenzol, Trimethoxybenzol, Naphthalin, 1,2-Dihydronaphthalin, 1,2,3,4-Tetrahydronaphthalin, Methylnaphthalin, Methoxynaphthalin, Ethoxynaphthalin, Chlornaphthalin, Bromnaphthalin, Biphenyl, Stilben, Inden, 4,4'-Dimethylbiphenyl, Fluoren, Phenanthren, Anthracen, 9,10-Dihydroanthracen, Triphenyl, Pyren, Perylen, Naphthacen, Coronen, Thiophen, Chromen, Xanthen, Tioxanthen, Benzofuran, Benzothiophen, Naphthothiophen, Thianthren, Diphenylenoxyd und Diphenylensulfid.

Beispiele für Anionen substituierter Cyclopentadiene sind die Anionen des Methyl-, Ethyl-, n-Propyl- und n-Butylcyclopentadiens oder die Anionen des Dimethylcyclopentadiens.

Wenn a 2 ist, stellt $R^2$ vorzugsweise je das gegebenenfalls substituierte Indenylanion oder insbesondere das Cyclopentadienylanion dar.

Der Index a ist vorzugsweise 1. Der Index b ist vorzugsweise 1.

$X^\ominus$ ist bevorzugt ein Anion der Formel $[LQ_m]^\ominus$.

Q ist vorzugsweise Fluor.

L ist vorzugsweise As oder Sb und insbesondere Sb.

Das Anion $X^\ominus$ kann aber auch ein Anion einer teil- oder perfluorierten aliphatischen oder aromatischen Sulfonsäure sein.

Bevorzugt handelt es sich dabei um Anionen von perfluoraliphatischen oder perfluoraromatischen organischen Sulfonsäuren.

Beispiele dafür sind Anionen von $C_1$-$C_8$ Perfluoralkanmonosulfonsäuren oder von Perfluorbenzol- oder Perfluortoluolmonosulfonsäure, wie $CF_3SO_3^-$ , $C_2F_5SO_3^-$ , $C_2F_7SO_3^-$ , $C_4F_9SO_3^-$ , $C_6F_{13}SO_3^-$ , $C_8F_{17}SO_3^-$ , $C_6F_5SO_3^-$ und $CF_3 \cdot C_6F_4SO_3^-$ .

Alle diese Anionen zeichnen sich durch eine sehr geringe Nukleophilie aus.

Bevorzugte Anionen $X^\ominus$ sind $PF_6^-$ , $AsF_6^-$ $SbF_6^-$ oder $SbF_5(OH)^-$.

Von diesen Anionen werden insbesondere $AsF_6^-$ und $SbF_6^-$ bevorzugt. Initiatoren mit diesen letzteren Anionen, insbesondere mit dem $SbF_6^-$ -Anion ergeben besonders schnell härtende Epoxidharzgemische.

Die Verbindungen der Formel I lassen sich in Analogie zu an sich bekannten Verfahren herstellen. Die Herstellung von Metallocenkomplexen dieses Typs mit komplexen Halogenidanionen ist z.B. in der EP-A-94.915 beschrieben.

Verbindungen der Formel I mit anderen Anionen lassen sich in Abweichung zu dem dort beschriebenen Verfahren herstellen, indem man anstelle eines Anions einer komplexen Säure ein Anion der Säure HX in an sich bekannter Weise einführt; dabei besitzt $X^\ominus$ die weiter oben definierte Bedeutung.

Bevorzugt wird ein Verfahren, worin das Epoxidharz in Schritt i) ein Diglycidylether auf Basis eines Bisphenols ist, insbesondere ein bromierter Diglycidylether auf Basis eines Bisphenols oder ein vorverlängerter Diglycidylether auf Basis eines Bisphenols.

Besonders bevorzugt wird ein Verfahren, worin das Epoxidharz in Schritt i) ein mit einer geringen Menge eines cyclischen Anhydrids einer Polycarbonsäure, insbesondere eines Anhydrids einer cycloaliphatischen Dicarbonsäure, modifizierter Diglycidylether auf Bisphenol Basis, insbesondere auf Bisphenol A Basis, der gegebenenfalls auch vorverlängert sein kann, ist.

Ebenfalls besonders bevorzugt wird ein Verfahren, worin das Epoxidharz in Schritt i) ein Diglycidylether auf Bisphenol Basis, insbesondere auf Bisphenol A Basis, der gegebenenfalls auch vorverlängert sein kann, ist, das zusammen mit einer geringen Menge eines Novolaks, insbesondere eines Kresol-Formaldehyd-Novolaks oder eines Phenol-Formaldehyd-Novolaks, eingesetzt wird.

Ferner wird ein Verfahren bevorzugt, worin der Initiator die Formel Ia besitzt

$$\left[ R^3 \; Fe^{II} \; R^4 \right]^\oplus \qquad X'^\ominus \qquad\qquad (Ia),$$

worin $R^3$ ein Stilbenrest oder ein ein- oder zweifach mit $C_1$-$C_4$ Alkyl oder mit $C_1$-$C_4$ Alkoxy substituierter Benzol- oder Naphthalinrest ist, insbesondere ein Cumol- oder ein Methylnaphthalinrest, $R^4$ ein unsubstitu-iertes Cyclopentadienylanion darstellt und $X'^\ominus$ ausgewählt wird aus der Gruppe bestehend aus $AsF_6^-$ und $SbF_6^-$ .

Besonders bevorzugt wird ein Verfahren, worin in Schritt iii) ein Pressdruck von 20-50 bar für 1-45 Minuten bei einer Temperatur von 80-200 °C, insbesondere 100-200 °C, angewendet wird.

Ganz besonders bevorzugt wird ein Verfahren, worin als faserförmiges Trägermaterial in Schritt i) Glasgewebe oder Papier verwendet wird.

Wie bereits weiter oben beschrieben, besitzen die ausgehärteten Schichtstoffe dieses Verfahrens gegenüber herkömmlich hergestellten Produkten verbesserte Endeigenschaften.

Die Erfindung betrifft also auch den gemäss obigem Verfahren erhältlichen Schichtpressstoff.

Ferner betrifft die Erfindung die Verwendung der Verbindungen der weiter oben definierten Formel I zur Herstellung von Schichtpressstoffen, vorzugsweise auf Epoxidbasis.

Die in Schritt i) eingesetzte härtbare Mischung kann noch weitere Zusatzstoffe enthalten.

Dabei kann es sich um Zusätze handeln, mit denen die Endeigenschaften der gehärteten Schichtpressstoffe und/oder die Verarbeitungseigenschaften der Mischung modifiziert werden.

Beispiele für solche Zusatzstoffe sind Füllstoffe oder Streckmittel, wie Kreide, Talkum, Kaolin, Glimmer, Gips, Titandioxid, Quarzmehl, Aluminiumoxid, Cellulose, Tonerde, gemahlener Dolomit, Wollastonit, Kieselerde mit grosser spezifischer Oberfläche (erhältlich unter dem Handelsnamen Areosil), mit langkettigen Aminen modifizierte Tonerde (erhältlich unter dem Namen Bentone), gepulvertes Polyvinylchlorid, Polyolefine oder Aminoplaste, sowie Metallpulver, wie Kupfer-, Silber-, Aluminium- oder Eisenpulver, Flammschutzmittel, wie Antiomontrioxid; Farbmittel, wie Pigmente oder Farbstoffe; Lichtstabilisatoren zur Verbesserung der UV-Beständigkeit des fertigen Schichtstoffes; Trennmittel, um beispielsweise die einzelnen in Schritt i) hergestellten Schichten zwischenzeitlich zu trennen, wie Trennfolien, filmbildende Lacke oder Wachse; Thixotropiemittel, wie hochdisperse Kieselsäure; reaktive Verdünnungsmittel, wie Phenyl-oder Kresylglycidylether, Butandioldiglycidylether oder Hexahydrophthalsäurediglycidylether; oder inerte Verdünnungsmittel, um beispielsweise Imprägnierlösungen aus hochviskosen oder festen Epoxidharzgemischen herzustellen, wie chlorierte aliphatische oder aromatische Kohlenwasserstoffe, z.B. Dichlormethan, Trichlorethan, Tetrachlorethan, Chlorbenzol, oder wie aromatische Kohlenwasserstoffe, wie Toluol oder Xylol, oder wie aliphatische Ketone, wie Aceton oder Methylethylketon.

Die erfindungsgemäss erhältlichen Schichtpresstoffe lassen sich insbesondere zur Herstellung von Leiterplatten und Isolationsmaterialien einsetzen.

Die folgenden Beispiele erläutern die Erfindung.

Beispiel 1: Es wird eine Lösung hergestellt aus 500 g eines in Methylethylketon gelösten bromierten technischen Diglycidylethers auf Basis von Bisphenol A (Epoxidgehalt: 2,30 Aequ./kg; Bromgehalt: 19,7 Gew. %) und 2,0 g ($\eta^6$-Isopropylbenzol)($\eta^5$-cyclopentadienyl)eisen(II)-hexafluoroantimonat (abgekürzt "Photoinitiator I"). Die Konzentration dieses Photoinitiators beträgt 0,5 Gewichtsprozent bezogen auf festes Epoxidharz in der Lösung.

Mit dieser Lösung werden Bahnen aus Glasgewebe (Flächengewicht 200 g/m$^2$) imprägniert; das imprägnierte Glasgewebe lässt man einige Minuten bei Raumtemperatur abtropfen, ehe es während 5 Min. bei 150°C in einem Abluftofen vom Lösungsmittel befreit wird. Die lösungsmittelfreien Bahnen werden während 120 Sec. mittels einer 5000 Watt Quecksilberhochdrucklampe bestrahlt, wobei der Abstand zwischen Glasgewebe und Lampe ca. 40 cm beträgt. Danach wird das Gewebe in Stücke von 15 x 15 cm geschnitten. Je 8 dieser Stücke werden zusammen in einer heizbaren Presse zu einem Schichtstoff verarbeitet; dabei wird zuerst während 15 Min. bei 80°C ein Druck von 40 bar, anschliessend während 10 Min. bei 180°C ein Druck von 40 bar angewendet. Die Glasumwandlungstemperatur des fertigen Laminats beträgt 153°C.

Beispiele 2-4: Wie in Beispiel 1 beschrieben, werden glasgewebeverstärkte Schichtstoffe hergestellt aus dem Epoxidharz gemäss Beispiel 1 und Photoinitiator I, dessen Menge in Gewichtsprozent, bezogen auf festes Epoxidharz, in Tabelle 1 angegeben ist. Sie enthält weiterhin Angaben über Trocknungszeit- und -temperatur, über die Belichtungszeit, und über den verwendeten Presszyklus, sowie über die erzielte Glasumwandlungstemperatur.

Beispiel 5: Wie in Beispiel 1 beschrieben, wird aus Photoinitiator I und einem in Methylethylketon gelösten bromierten technischen Diglycidylether auf Basis von Bisphenol A (Epoxidgehalt: 2,8 Aequ./kg; Bromgehalt: 20,3 Gew. %) ein Schichtstoff hergestellt. Die Menge des Photoinitiators in Gewichtsprozent des lösungsmittelfreien Harzes, Trocknungs- und Belichtungszeit, Pressbedingungen sowie Glasumwandlungstemperatur des fertigen Laminats sind in Tabelle 1 aufgeführt.

7

Tabelle 1

| Beispiel Nr. | Menge Photoinitiator I bezogen auf Festharz | Trocknung im Abluftschrank | Belichtungszeit | Presszyklus Druck: 40 bar | $T_g$ des Laminates |
|---|---|---|---|---|---|
| 2 | 1,0 | 5 Min./150°C | 60 Sec. | 15'/90° + 20'/170° | 153°C |
| 3 | 1,0 | 5 Min./150°C | 15 Sec. | 15'/130° + 5'/180° | 154°C |
| 4 | 0,5 | 5 Min./150°C | 30 Sec. | 5'/130° + 10'/180° | 150°C |
| 5 | 1,0 | 5 Min/150°C | 60 Sec. | 15'/90° + 20'/180° | 182°C |

Beispiel 6: 6,0 g "Photoinitiator I" werden in 594 g flüssigem, bromiertem, lösungsmittelfreiem Diglycidylether auf Basis von Bisphenol A (Epoxidgehalt: 4,3 Aequ./kg; Bromgehalt: 20,5 Gew. %) bei Raumtemperatur gelöst. Mit diesem Harz werden Bahnen aus Glasgewebe (200 g/m² Flächengewicht) imprägniert, man lässt das getränkte Glasgewebe einige Minuten abtropfen ehe es, wie in Beispiel 1 beschrieben, während 120 Sec. mit UV-Licht bestrahlt wird. Anschliessend wird das getränkte Gewebe in Stücke von 15 x 15 cm zerschnitten; je 8 dieser Stücke werden aufeinander gelegt, in einer heizbaren Presse zu einem Schichtpresskörper verarbeitet, wobei während 20 Min. bei 180°C ein Druck von 20-30 bar aufgebracht wird. Die Glasumwandlungstemperatur des fertigen Laminats beträgt 170°C.

Beispiel 7: 10,0 g ($\eta^6$-1-Methylnaphthalin) ($\eta^5$-cyclopentadienyl)-eisen(II)-hexafluorantimonat (abgekürzt "Photoinitiator II") werden zu 612,5 g des bromierten Epoxidharzes gemäss Beispiel 1 gegeben. Die Konzentration dieses Photoinitiators beträgt 2 Gewichtsprozent bezogen auf festes Epoxidharz. Mit dieser Lösung werden Bahnen aus Glasgewebe (Flächengewicht 200 g/m²) getränkt, das imprägnierte Gewebe lässt man ca. 5 Min. bei Raumtemperatur abtropfen, ehe es während 5 Min. bei 150°C in einem Umluftofen vom Lösungsmittel befreit wird. Die lösungsmittelfreien Bahnen werden in 15 x 15 cm grosse Stücke zerschnitten.

Je 8 dieser Stücke werden zusammen in einer Presse zu einem Laminat verpresst, dabei wird zuerst während 10 Min. bei 130°C ein Druck von 20 bar, anschliessend während 20 Min. bei 150°C ein Druck von 50 bar angewandt. Die Glasumwandlungstemperatur des Laminats beträgt 142°C.

Beispiel 8: 12,0 g "Photoinitiator II" werden in 588 g flüssigem, lösungsmittelfreiem Epoxidharz gemäss Beispiel 6 bei Raumtemperatur gelöst. Mit diesem Harz werden Bahnen aus Glasgewebe (200 g/m² Flächengewicht) imprägniert; man lässt das getränkte Gewebe einige Minuten abtropfen, ehe es in Stücke von 15 x 15 cm zerschnitten wird. Je 8 dieser Stücke werden zusammen in einer Presse zu einem Schichtstoff verpresst; dabei wird zuerst während 5 Min. bei 150°C ein Druck von 20 bar, anschliessend während 10 Min. bei 180°C ein Druck von 40 bar angewandt. Die Glasumwandlungstemperatur des so erhaltenen Laminats beträgt 169°C.

Beispiel 9: Es wird eine Lösung hergestellt aus 915 g eines in Methylethylketon gelösten Gemisches aus bromiertem technischem Diglycidylether auf Basis von Bisphenol und einer geringen Menge des Glycidylethers von 1,1,2,2-Tetrakis-(4-hydroxyphenyl)-ethan (Epoxidgehalt 2,34 Aeq/kg; Bromgehalt 18,9 %) und 3,2 g "Photoinitiator I"; die Konzentration dieses Photoinitiators beträgt 0,5 Gewichtsprozent bezogen auf festes Epoxidharz in der Lösung. Wie in Beispiel 1 beschrieben, werden glasgewebeverstärkte Schichtstoffe hergestellt. In Tabelle 2 werden Trocken- und Belichtungszeit, Presszyklus und erzielte Glasumwandlungstemperatur $T_g$ angegeben.

Beispiel 10: Es wird eine Lösung hergestellt aus 900 g eines in Methylethylketon gelösten, bromierten technischen Diglycidylethers auf Basis von Bisphenol A (Epoxidgehalt 1,86 Aeq/kg; Bromgehalt 22,1 %) und 3,15 g "Photoinitiator I"; die Konzentration des Initiators ist 0,5 Gewichtsprozent, bezogen auf festes Epoxidharz. Mit dieser Lösung werden, wie in Beispiel 1 beschrieben, glasfaserverstärkte Schichtstoffe hergestellt. Trocken- und Belichtungszeit, Presszyklus und erzielte Glasumwandlungstemperatur sind in Tabelle 2 angegeben.

Beispiel 11: Es wird eine Lösung hergestellt aus 1000 g eines in Methylglykol und Methylethylketon gelösten, bromierten technischen Diglycidylethers auf Basis von Bisphenol A (Epoxidgehalt 2,55 Aeq/kg; Bromgehalt 21,5 %), der eine geringe Menge eines glycidylisierten Novolaks enthält, und 7,5 g "Photoinitiator I"; seine Konzentration beträgt 1,0 %, bezogen auf Festharz in der Lösung. Wie in Beispiel 1 beschrieben, wird mit dieser Lösung ein glasfaserverstärkter Schichtstoff hergestellt; Trocken- und Belichtungszeit, Presszyklus und Glasumwandlungstemperatur sind in Tabelle 2 angegeben.

Beispiel 12: Es wird eine Lösung hergestellt aus 800 g eines in Methylethylketon gelösten, bromierten technischen Diglycidylethers auf Basis von Bisphenol A (Epoxidäquivalent 1,88 Aeq/kg; Bromgehalt 19,5 %), und einer geringen Menge eines Phenolnovolaks sowie 3,2 g "Photoinitiator I"; seine Konzentration beträgt 0,50 % auf Festharz in der Lösung. Wie in Beispiel 1 beschrieben, wird mit dieser Lösung ein glasfaserverstärkter Schichtstoff hergestellt. Trocken- und Belichtungszeit, Presszyklus und Glasumwandlungstemperatur sind in Tabelle 2 angegeben.

Beispiel 13: Es wird eine Lösung hergestellt aus 800 g eines in Methylethylketon gelösten, bromierten technischen Diglycidylethers auf Basis von Bisphenol A und Tetrahydrophthalsäureanhydrid (Epoxidäquivalent 1,83 Aeq/kg; Bromgehalt 19,4 %), sowie 3,2 g "Photoinitiator I"; seine Konzentration beträgt 0,5 % bezogen auf Festharz in der Lösung. Wie in Beispiel 1 beschrieben, wird mit dieser Lösung ein glasfaserverstärkter Schichtstoff fabriziert. Trocken- und Belichtungszeit, Presszyklus und Glasumwandlungstemperatur sind in Tabelle 2 aufgeführt.

Beispiel 14: Es wird eine Lösung hergestellt aus 800 g eines in Methylethylketon gelösten, bromierten technischen Diglycidylethers auf Basis von Bisphenol A und Hexahydrophthalsäureanhydrid (Epoxidäquivalent 1,83 Aeq/kg; Bromgehalt 19,5 %), sowie 3,2 g "Photoinitiator I"; seine Konzentration beträgt 0,5 % bezogen auf Festharz in der Lösung. Wie in Beispiel 1 beschrieben, wird mit dieser Lösung ein glasfaserverstärkter Schichtstoff gepresst. Trocken- und Belichtungszeit, Presszyklus und Glasumwandlungstemperatur sind in Tabelle 2 aufgeführt.

Beispiel 15: 1,0 g "Photoinitiator I" werden in 400 g flüssigem, lösungsmittelfreiem 3,4-Epoxicyclohexylmethyl-3',4'-epoxicyclohexancarboxylat gelöst. Mit diesem Harz werden Bahnen aus Glasgewebe (200 g/m$^2$ Flächengewicht) imprägniert, man lässt es einige Minuten abtropfen, ehe es während 15 sec. mit UV-Licht bestrahlt wird. Anschliessend werden je 8 ca. 15 x 15 cm grosse Stücke des getränkten Gewebes aufeinander gelegt und in einer heizbaren Presse während 15 min. bei 170°C bei einem Druck von 20-30 Kp/cm$^2$ zu einem Schichtpresskörper verarbeitet, dessen Glasumwandlungstemperatur 135°C beträgt.

Beispiel 16: Mit der im Beispiel 10 erwähnten Lösung werden, wie im Beispiel 1 beschrieben Glasgewebebahnen imprägniert und getrocknet. Die imprägnierten Bahnen werden mit einer Geschwindigkeit von 7 m/min unter einer UV-Lampe hindurchgeführt (Fusion-D-lamps, 120 W/cm). Anschliessend werden die belichteten Prepregs geschnitten und verpresst wie in Beispiel 1. In Tabelle 2 werden Trocken- und Belichtungszeit, Presszyklus und erzielte Glasumwandlungstemperatur $T_g$ angegeben.

Beispiel 17: Es wird eine Lösung hergestellt aus 375 g des in Beispiel 1 erwähnten Epoxidharzes und 0,75 g "Photoinitiator I" sowie 3,0 g ($\eta^6$-Stilben)($\eta^5$-cyclopentadienyl)eisen (II)-hexafluorophosphat, d.h. 0,25 % bzw. 1,0 % bezogen auf Festharz in der Lösung. Wie in Beispiel 1 beschrieben, werden glasgewebeverstärkte Schichtstoffe hergestellt. In Tabelle 2 werden Trocken- und Belichtungszeit, Presszyklus und erzielte Glasumwandlungstemperatur $T_g$ angegeben.

Beispiel 18: Es wird eine Lösung hergestellt aus 563 g des in Beispiel 1 erwähnten Epoxidharzes und 2,25 g ($\eta^6$-Stilben)($\eta^5$-cyclopentadienyl)-eisen (II)-hexafluoroantimonat; die Konzentration des Initiators beträgt 0,5 % bezogen auf festes Epoxidharz. Wie in Beispiel 1 beschrieben wird diese Lösung zur Herstellung eines glasfaserverstärkten Schichtstoffes verwendet, die Trocknungs- und Belichtungszeiten sowie Pressbedingungen und Glasumwandlungspunkt sind in Tabelle 2 zitiert.

Tabelle 2

| Beispiel Nr. | Trocknung im Abluftschrank | Belichtungszeit (sec.) | Presszyklus *) | | $T_g$ (°C) |
|---|---|---|---|---|---|
| | | | Zeit | Temperatur | |
| 9 | 5 min /140°C | 30 | 15' / 170°C | | 150 |
| 10 | 5 min /140°C | 60 | 10' / 180°C | | 143 |
| 11 | 5 min /150°C | 120 | 15' / 100°C + 20' / 180°C | | 153 |
| 12 | 5 min /170°C | 30 | 10' / 180°C | | 144 |
| 13 | 2 min /190°C | 30 | 3' / 200°C | | 139 |
| 14 | 5 min /150°C | 30 | 3' / 200°C | | 141 |
| 16 | 5 min /140°C | - | 10' / 170°C | | 142 |
| 17 | 2 min /190°C | 30 | 15' / 180°C | | 139 |
| 18 | 5 min /150°C | 30 | 15' / 170°C | | 144 |

*) Druck: 20-30 (bar)

**Patentansprüche**

1. Verfahren zur Herstellung eines Schichtpresstoffes umfassend die Schritte
   i) Herstellung einer Schicht durch Kontaktieren eines faserförmigen Trägermaterials mit einer härtbaren Mischung enthaltend a) ein Epoxidharz mit durchschnittlich wenigstens zwei 1,2-Epoxidgruppen pro Molekül oder eine Mischung dieser Epoxidharze und b) eine Verbindung der Formel I oder eine Mischung dieser Verbindungen

$$\left[ R^1(Fe^{II}R^2)_a \right]^{ab\oplus} \quad ab \cdot \left[ X \right]^{\ominus} \qquad (I),$$

   worin a und b unabhängig voneinander 1 oder 2 sind, $R^1$ ein $\pi$-Aren ist, $R^2$ ein $\pi$-Aren oder ein Indenyl- oder Cyclopentadienylanion bedeutet, $X^-$ ein Anion $[LQ_m]^-$ oder ein Anion einer teil- oder perfluorierten aliphatischen oder aromatischen Sulfonsäure ist, L P, As oder Sb bedeutet, Q Fluor ist oder ein Teil der Reste Q auch Hydroxylgruppen sein können, und m der um Eins vergrösserten Wertigkeit von L entspricht,
   ii) Herstellen einer Schichtfolge aus mindestens zwei schichtförmigen, miteinander zu verbindenden Materialien, wovon mindestens eines davon eine gemäss Schritt i) erhältliche Schicht ist, bei der das härtbare Material im wesentlichen in unveränderter Form vorliegt, und
   iii) Verpressen besagter Schichtfolge bei erhöhter Temperatur, wobei Druck und Temperatur so gewählt werden, dass zu Beginn dieses Schrittes ein flüssiges Matrixharz vorliegt, bei dem anfänglich ein Viskositätsabfall erfolgt, so dass eingeschlossene Gase praktisch vollständig aus der Schichtfolge entweichen können, und dass bei der folgenden Vernetzungsreaktion der Viskositätsanstieg so rasch erfolgt, dass das ausfliessende Harz das Presswerkzeug nicht verklebt.

2. Verfahren gemäss Anspruch 1, worin vor Schritt ii) noch ein Bestrahlungsschritt ia) eingeschaltet ist, worin die Verbindung der Formel I zur Aktivierung mit aktinischer Strahlung bestrahlt wird.

3. Verfahren gemäss Anspruch 1, worin Schritte ii) und iii) kontinuierlich ausgeführt werden.

4. Verfahren gemäss Anspruch 1, worin das Epoxidharz in Schritt i) ein Diglycidylether auf Basis eines Bisphenols ist.

5. Verfahren gemäss Anspruch 1, worin das Epoxidharz in Schritt i) ein mit einer geringen Menge eines cyclischen Anhydrids einer Polycarbonsäure, insbesondere eines Anhydrids einer cycloaliphatischen Dicarbonsäure, modifizierter Diglycidylether auf Bisphenol Basis, insbesondere auf Bisphenol A Basis, der gegebenenfalls auch vorverlängert sein kann, ist; oder worin besagter Diglycidylether zusammen mit einer geringen Menge eines Novolaks, insbesondere eines Kresol-Formaldehyd-Novolaks oder eines Phenol-Formaldehyd-Novolaks, eingesetzt wird.

6. Verfahren gemäss Anspruch 1, worin der Initiator die Formel Ia besitzt

$$\left[ R^3 \ Fe^{II} \ R^4 \right]^{\oplus} \quad X'^{\ominus} \qquad (Ia),$$

   worin $R^3$ ein Stilbenrest oder ein ein- oder zweifach mit $C_1$-$C_4$-Alkyl oder mit $C_1$-$C_4$-Alkoxy substituierter Benzol- oder Naphthalinrest ist, $R^4$ ein unsubstituiertes Cyclopentadienylanion darstellt und $X'^{\ominus}$ ausgewählt wird aus der Gruppe bestehend aus $AsF_6^-$ und $SbF_6^-$.

7. Verfahren gemäss Anspruch 1, worin in Schritt iii) ein Pressdruck von 20-50 bar für 1-45 Minuten bei einer Temperatur von 80-200 °C angewendet wird.

**8.** Verfahren gemäss Anspruch 1, worin als faserförmiges Trägermaterial in Schritt i) Glasgewebe oder Papier verwendet wird.

**9.** Verwendung der Verbindungen der Formel I gemäss Anspruch 1 zur Herstellung von Schichtpresstoffen.

**Claims**

**1.** A process for the preparation of a moulded, laminate comprising the steps of
   i) preparation of a layer by bringing a fibrous substrate into contact with a curable mixture comprising a) an epoxy resin having on average at least two 1,2-epoxide groups per molecule or a mixture of these epoxy resins and b) a compound of the formula I

$$\left[ R^1(Fe^{II}R^2)_a \right]^{ab\oplus} \quad ab\cdot\left[ X \right]^{\ominus} \qquad (I),$$

or a mixture of these compounds, in which a and b are, independently of one another, 1 or 2, $R^1$ is a $\pi$-arene, $R^2$ is a $\pi$-arene or an indenyl or cyclopentadienyl anion, $X^-$ is an anion $[LQ_m]^-$ or an anion of a partly fluorinated or perfluorinated aliphatic or aromatic sulfonic acid, L is P, As or Sb, Q is fluorine or else some of the radicals Q may be hydroxyl groups, and m corresponds to the valence of L increased by one,
   ii) preparation of a layer sequence from at least two layered materials which are to be bonded together, at least one of which is a layer which is obtainable according to step i), in which the curable material is essentially present in its unaltered state, and
   iii) compression moulding of said layer sequence at elevated temperature, in which pressure and temperature are selected such that a liquid resin matrix is present at the beginning of this step, in which matrix a fall in viscosity occurs initially, so that entrained gases can escape almost entirely from the layer sequence, and that in the subsequent crosslinking reaction the rise in viscosity occurs so quickly that the resin which flows out does not cause sticking of the compression mould.

**2.** A process according to claim 1 wherein before step ii), an irradiation step ia) is inserted in which the compound of the formula I is exposed to actinic radiation for activation.

**3.** A process according to claim 1, wherein steps ii) and iii) are carried out continuously.

**4.** A process according to claim 1, wherein the epoxy resin in step i) is a diglycidyl ether based on a bisphenol.

**5.** A process according to claim 1, wherein the epoxy resin in step i) is a bisphenol-based diglycidyl ether, which may be advanced if desired, which is modified with a small amount of a cyclic anhydride of a polycarboxylic acid, especially of an anhydride of a cycloaliphatic dicarboxylic acid; or wherein said diglycidyl ether is used together with a small quantity of a novolak, especially of a cresol-formaldehyde novolak or of a phenol-formaldehyde novolak.

**6.** A process according to claim 1, wherein the initiator has the formula Ia

$$\left[ R^3\,Fe^{II}\,R^4 \right]^{\oplus} \quad X'^{\ominus} \qquad\qquad (Ia),$$

in which $R^3$ is a stilbene radical or is a benzene or naphthalene radical having one or two $C_1$-$C_4$ alkyl or $C_1$-$C_4$ alkoxy substituents, $R^4$ is an unsubstituted cyclopentadienyl anion and $X'^{\ominus}$ is selected from the group consisting of $AsF_6^-$ and $SbF_6^-$.

11

**7.** A process according to claim 1, wherein in step iii) a moulding pressure of 20-50 bar is applied for 1-45 minutes at a temperature of 80-200°C.

**8.** A process according to claim 1, wherein glass fabric or paper is used as the fibrous substrate in step i).

**9.** The use of compounds of the formula I according to claim 1 for the preparation of moulded laminates.

**Revendications**

**1.** Procédé pour fabriquer un stratifié plastique, qui comprend les étapes consistant :
i) à fabriquer une couche par mise en contact d'un matériau support fibreux avec un mélange durcissable contenant a) une résine époxyde ayant en moyenne au moins deux groupes 1,2-époxyde par molécule, ou encore un mélange de ces résines époxydes et b) Un composé de formule I, ou un mélange de ces composés

$$\left[ \ R^1(Fe^{II})R^2)_a \ \right]^{ab+} \qquad ab. \left[ \ X \ \right]^{-} \qquad (I),$$

dans laquelle a et b, indépendamment l'un de l'autre, valent chacun 1 ou 2, $R^1$ est un radical arène $\pi$, $R^2$ est un arène $\pi$ ou un anion indényle ou cyclopentadiényle, $X^-$ est un anion $[LQ_m]^-$ ou un anion d'un acide sulfonique aliphatique ou aromatique partiellement fluoré ou perfluoré, L représente P, As ou Sb, Q est le fluor, ou encore une partie des radicaux Q peuvent aussi représenter des groupes hydroxyle, et m correspond à la valence de L augmentée de 1,
ii) à fabriquer une séquence de couches constituée d'au moins deux matériaux en forme de couche, destinés à être liés l'un à l'autre, dont au moins l'un est une couche pouvant être obtenue par l'étape i), dans laquelle le matériau durcissable est présent sous une forme essentiellement non modifiée, et
iii) à comprimer la séquence de couches ci-dessus à haute température, en choisissant la pression et la température de façon que l'on soit en présence, au début de cette étape, d'une résine de matrice liquide, où on a au début une chute de viscosité, de façon que les gaz inclus puissent s'échapper presque complètement de la séquence de couches, et que, lors de la réaction ultérieure de réticulation, l'élévation de viscosité soit tellement rapide que la résine qui s'échappe ne colle pas le moule de compression.

**2.** Procédé selon la revendication 1, dans lequel l'étape ii) est encore précédée d'une étape d'exposition à un rayonnement ia), dans laquelle le composé de formule I est exposé, pour activation, à un rayonnement actinique.

**3.** Procédé selon la revendication 1, dans lequel les étapes ii) et iii) sont mises en oeuvre d'une manière continue.

**4.** Procédé selon la revendication 1, dans lequel la résine époxyde de l'étape i) est un éther diglycidylique d'un bisphénol.

**5.** Procédé selon la revendication 1, dans lequel la résine époxyde de l'étape i) est un éther diglycidylique d'un bisphénol, en particulier du bisphénol A, pouvant être éventuellement aussi soumis à une pré-extension, l'éther étant modifié par une faible quantité d'un anhydride cyclique d'un acide polycarboxy-lique, en particulier un anhydride d'un acide dicarboxylique cycloaliphatique ; ou encore où l'éther diglycidylique mentionné ci-dessus est utilisé en même temps qu'une faible quantité d'une novolaque, en particulier d'une novolaque crésolformaldéhyde ou d'une novolaque phénol-formaldéhyde.

**6.** Procédé selon la revendication 1, dans lequel l'amorceur a la formule Ia

[ $R^3$ Fe$^{II}$ $R^4$ ]+ X'-     (Ia)

dans laquelle $R^3$ est un résidu stilbène ou un résidu benzène ou naphtalène substitué une ou deux fois par des substituants alkyle en $C_1$-$C_4$ ou alcoxy en $C_1$-$C_4$, $R^4$ est un anion cyclopentadiényle non substitué, et X'- est choisi parmi l'ensemble comprenant $AsF_6^-$ et $SbF_6^-$.

7. Procédé selon la revendication 1, dans lequel, dans l'étape iii), on utilise une pression de compression de 20 à 50 bar pendant 1 à 45 min à une température de 80 à 200°C.

8. Procédé selon la revendication 1, dans lequel on utilise comme matériau support fibreux dans l'étape i) un tissu de verre ou du papier.

9. Utilisation des composés de formule I selon la revendication 1 pour fabriquer des stratifiés.